# EUROPEAN PATENT APPLICATION

(11) **EP 4 556 344 A1**
(43) Date of publication of application: **21.05.2025**
(21) Application number: 23871543.7
(22) Date of filing: 16.08.2023
(51) Int. Cl.: B61B 13/00, B61B 3/02

(54) **OVERHEAD TRAVELING VEHICLE SYSTEM**

(30) Priority: 29.09.2022 JP 2022156082
(71) Applicant: Murata Machinery, Ltd., Kyoto-shi, Kyoto 601-8326 (JP)
(72) Inventor: TORAZAWA, Masayoshi, Inuyama-shi, Aichi 484-8502 (JP)
(74) Representative: Stöckeler, Ferdinand
(86) International application number: PCT/JP2023/029636
(87) International publication number: WO 2024/070301

(57) **Abstract**

An overhead traveling vehicle system includes a track at least partially disposed in a grid pattern, and an overhead traveling vehicle including a traveling section configured to travel along the track, and a main body disposed below the track and suspended from the traveling section. The traveling section includes a traveling wheel configured to roll on the track about a rotation axis as a principal axis, and a traveling drive motor configured to drive the traveling wheel. The traveling drive motor is provided on the rotation axis of the traveling wheel.

## Description

### Technical Field

One aspect of the present invention relates to an overhead traveling vehicle system.

### Background Art

An overhead traveling vehicle system is known, which includes a track arranged in a grid pattern, and an overhead traveling vehicle having a traveling section that travels along the track and a main body disposed below the track and suspended from the traveling section (see, for example, Patent Literature 1). In such an overhead traveling vehicle system, the traveling section includes a traveling wheel that rolls on the track about a rotation axis as a principal axis, and a traveling drive motor that drives the traveling wheel. The traveling drive motor is provided below the track and transmits a driving force to the traveling wheel via a transmission mechanism including a belt.

### Citation List

### Patent Literature

Patent Literature 1: Japanese Patent No. 7070704

### Summary of Invention

### Technical Problem

In the overhead traveling vehicle system described above, for example, the height dimension from the traveling drive motor to the traveling wheel may be relatively large, and it is desired to downsize the traveling section.

An aspect of the present invention is therefore to provide an overhead traveling vehicle system in which the traveling section can be downsized.

### Solution to Problem

(1) An overhead traveling vehicle system according to one aspect of the present invention includes: a track at least partially disposed in a grid pattern; and an overhead traveling vehicle including a traveling section configured to travel along the track, and a main body disposed below the track and suspended from the traveling section. The traveling section includes a traveling wheel configured to roll on the track about a rotation axis as a principal axis, and a traveling drive motor configured to drive the traveling wheel. The traveling drive motor is disposed on the rotation axis of the traveling wheel.
   In the overhead traveling vehicle system, a space above the track can be effectively utilized to arrange the traveling drive motor. As a result, for example, the height dimension from the traveling drive motor to the traveling wheel is reduced, so that the traveling section can be downsized.
(2) In the overhead traveling vehicle system according to (1), the track may have a plurality of first rails extending along a first direction and a plurality of second rails extending along a second direction intersecting the first direction. A support wall may be connected to an upper surface of each of the first rails and the second rails. The support wall may have a notch that allows passage of the traveling drive motor during traveling of the overhead traveling vehicle. In this case, the support wall can increase the strength of the track, and the notch can avoid interference of the traveling drive motor with the support wall.
(3) In the overhead traveling vehicle system according to (1) or (2), the traveling wheel may be capable of swiveling. The overhead traveling vehicle system may further include a steering driver configured to swivel the traveling wheel. The steering driver may be disposed below the track and below the traveling wheel. In this case, the steering driver can be arranged in a dead space below the track and below the traveling wheel. It is unnecessary to arrange the steering driver, for example, between the upper surface of the main body and the track, so that the height dimension of the overhead traveling vehicle can be reduced. As a result, the overhead traveling vehicle can be downsized.
(4) In the overhead traveling vehicle system according to any one of (1) to (3), the traveling drive motor may have an outer shape included in an outer shape of the traveling wheel, as viewed from an axial direction of the rotation axis. In this case, size increase of the traveling section due to the traveling drive motor can be suppressed.
(5) The overhead traveling vehicle system according to (2) may further include a support section configured to support the traveling wheel such that the traveling wheel is rotatable, a coupling section coupled to a lower portion of the support section, and a cable electrically connected to the traveling drive motor. The track may include a plurality of intersection rails disposed with a gap from each of end portions of the first rails and end portions of the second rails. The coupling section and the cable may extend from above to below the track through the gap. With this configuration, the strength of a portion extending from above to below the track through the gap (hereinafter may be referred to as "narrow portion") can be increased, compared with when a transmission mechanism such as a belt that transmits a driving force to the traveling wheel is included.

### Advantageous Effects of Invention

One aspect of the present invention provides an overhead traveling vehicle system in which the traveling section can be downsized.

### Brief Description of Drawings

[FIG. 1] FIG. 1 is a perspective view of an example of an overhead traveling vehicle system according to an embodiment.
[FIG. 2] FIG. 2 is an exploded perspective view of four rail units that constitute a rail assembly in FIG. 1 and a coupling member that couples them.
[FIG. 3] FIG. 3 is a side view of an overhead traveling vehicle in FIG. 1.
[FIG. 4] FIG. 4 is a perspective view of the overhead traveling vehicle in FIG. 1.
[FIG. 5] FIG. 5 is a perspective view of a rail section alone of the rail assembly.
[FIG. 6] FIG. 6 is a cross-sectional view of a coupling section between a plurality of rail units.
[FIG. 7] FIG. 7 is a side view of a traveling section, a wheel swiveling mechanism, and a track.
[FIG. 8] FIG. 8 is a cross-sectional view of the traveling section.
[FIG. 9] FIG. 9 is a perspective view of the traveling section and the wheel swiveling mechanism.
[FIG. 10] FIG. 10 is a perspective view illustrating a state in which the interior of a gearbox in FIG. 9 is exposed.
[FIG. 11] FIG. 11 is a cross-sectional perspective view of the traveling section and the wheel swiveling mechanism in FIG. 9.

### Description of Embodiments

Embodiments will be described below with reference to the drawings. In a description of the drawings, like elements are denoted by like signs and an overlapping description is omitted. In the drawings, for convenience of explanation, each configuration according to an embodiment is represented at a different scale as appropriate. In some drawings, an XYZ Cartesian coordinate system is depicted. In the following description, this coordinate system will be referred to for ease of explanation. In the following description, one direction along a horizontal plane is X direction (first direction), a direction orthogonal to the X direction and along the horizontal plane is Y direction (second direction), and the vertical direction is Z direction.

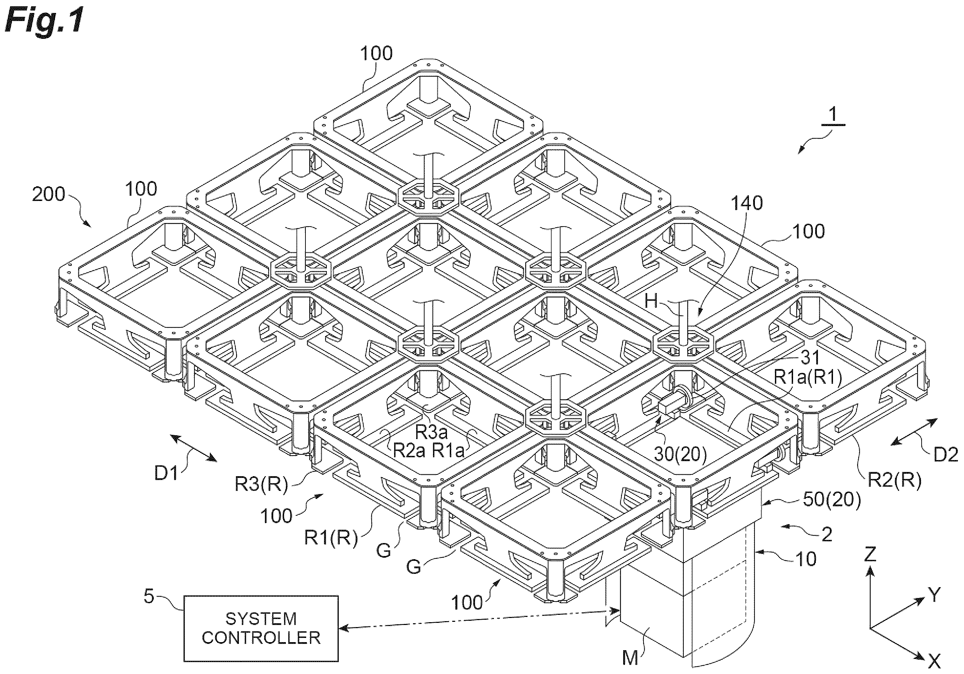

As illustrated in FIG. 1, an overhead traveling vehicle system 1 according to an embodiment is a grid system (transport system) for transporting an article M using an overhead traveling vehicle 2, for example, in a clean room of a semiconductor fabrication plant. The overhead traveling vehicle system 1 includes, for example, a plurality of overhead traveling vehicles 2 (hereinafter collectively referred to as "traveling vehicle 2"), a system controller 5 that controls the traveling vehicles 2, and a track R on which the traveling vehicles 2 travel. Each of the traveling vehicles 2 moves along the track R of the overhead traveling vehicle system 1. The traveling vehicle 2 travels along the track R and transports an article M, such as a front opening unified pod (FOUP) that accommodates semiconductor wafers, or a reticle pod that accommodates reticles. The traveling vehicle 2 may be referred to as carriage, transport vehicle, transport carriage, traveling carriage, or the like. A plurality of traveling vehicles 2 enable high-density transportation of articles M and improve the efficiency of transporting articles M. The overhead traveling vehicle system 1 may include only one traveling vehicle 2.

The track R is provided on a ceiling or in the vicinity of a ceiling of a building such as a clean room. The track R is provided adjacent to, for example, processing equipment, a stocker (automatic warehouse), or the like. The processing equipment includes, for example, exposure equipment, coater/developer, deposition equipment, etching equipment, and the like, and performs various processing on a semiconductor wafer in the article M transported by the traveling vehicle 2. The stocker stores an article M to be transported by the traveling vehicle 2.

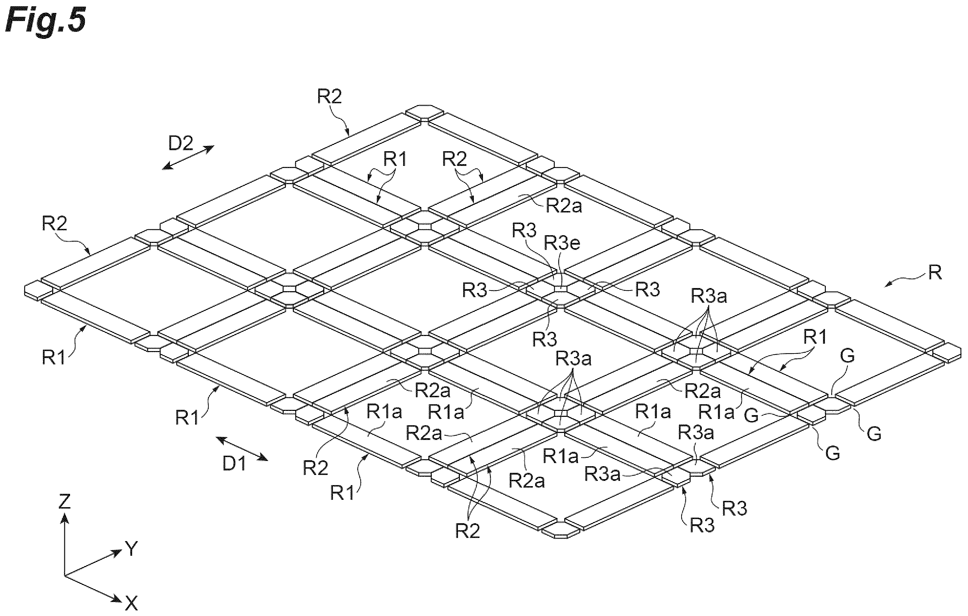

The track R is arranged in a grid pattern in plan view (see also FIG. 5). The track R extends along the horizontal direction. In the present embodiment, the track R is constructed such that a plurality of rail units 100 each including a first rail R1, a second rail R2, and an intersection rail R3 are aligned in the X and Y directions. The overhead traveling vehicle system 1 includes a plurality of rail units 100 aligned in the X and Y directions, and a plurality of coupling members 140 that couple the rail units 100 to each other. The rail units 100 and the coupling members 140 form a rail assembly 200. The rail assembly 200 is suspended from a not-illustrated ceiling or the like by a plurality of suspension members H at sections where the rail units 100 are coupled to each other by the coupling members 140.

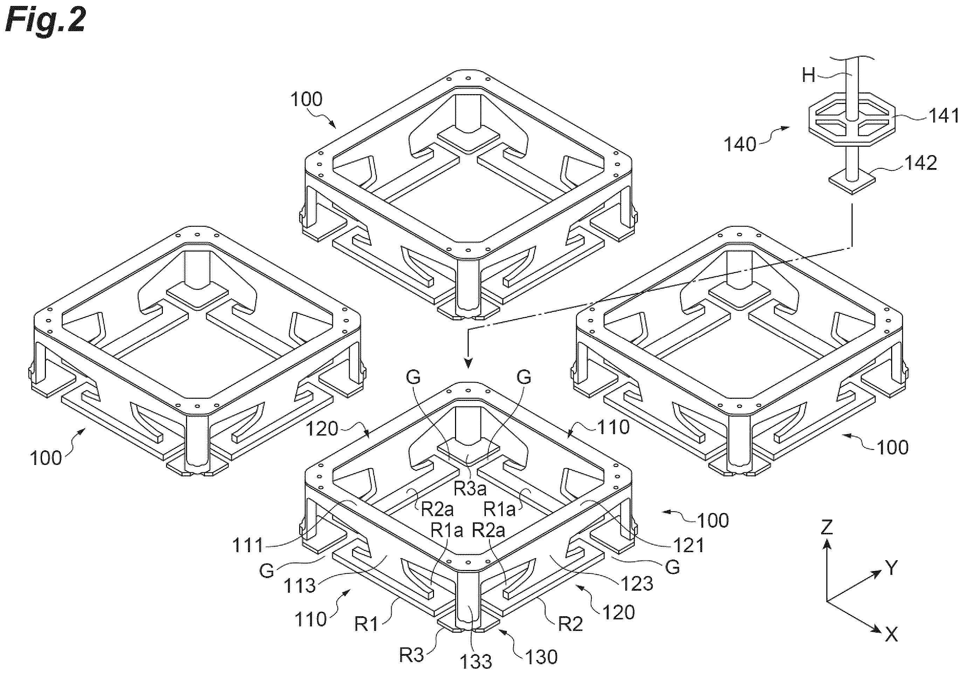

FIG. 2 is an exploded view of four rail units 100 that constitute the rail assembly 200 in FIG. 1 and the coupling member 140 that couples them. The rail units 100 are each a rectangular parallelepiped-shaped (frame-shaped) member and have the same configuration. Each of the rail units 100 includes two first rail members 110 arranged along the X direction, two second rail members 120 arranged along the Y direction, and four intersection rail members 130 arranged such that a gap is formed on extension lines of the first rail member 110 and the second rail member 120 (that is, at an intersection of the grid). When the rail unit 100 is viewed in plan view, two parallel first rail members 110 and two parallel second rail members 120 are arranged in a square shape, and four intersection rail members 130 are arranged at the apexes of the square.

Each rail unit 100 is made of, for example, metal and is a unit in which the first rail members 110, the second rail members 120, and the intersection rail members 130 are each formed and then integrated. Each of the first rail members 110 includes a first beam portion 111 arranged at an upper end position of the rail unit 100 and extending in the X direction, a first rail R1 arranged at a lower end position of the rail unit 100 and extending in the X direction, and a first support wall 113 arranged between the first beam portion 111 and the first rail R1 and joined to the first beam portion 111 and the first rail R1. Each of the second rail members 120 includes a second beam portion 121 arranged at an upper end position of the rail unit 100 and extending in the Y direction, a second rail R2 arranged at a lower end position of the rail unit 100 and extending in the Y direction, and a second support wall 123 arranged between the second beam portion 121 and the second rail R2 and joined to the second beam portion 121 and the second rail R2. A plurality of first beam portions 111 and a plurality of second beam portions 121 form a grid-like structure that extends along an XY plane at an upper end position of the rail assembly 200. The first support wall 113 extends along an XZ plane. The second support wall 123 extends along a YZ plane.

The intersection rail member 130 includes an intersection support column 133 extending along the Z direction (vertical direction) at a position where the first beam portion 111 and the second beam portion 121 are joined at a right angle, and an intersection rail R3 provided at a lower end of the intersection support column 133.

As illustrated in FIG. 1 and FIG. 5, a plurality of first rails R1 each extend along the X direction. A plurality of second rails R2 each extend along the Y direction. The track R is formed in a grid pattern in plan view with a plurality of first rails R1 and a plurality of second rails R2. The track R has a plurality of first rails R1 and a plurality of second rails R2 to form a plurality of squares. The intersection rail R3 is arranged at a section corresponding to the intersection of the first rail R1 and the second rail R2. The intersection rail R3 is adjacent to the first rail R1 with a spacing in the X direction and adjacent to the second rail R2 with a spacing in the Y direction. The intersection rail R3 is used in any of a case where the traveling vehicle 2 travels along the first rail R1, a case where the traveling vehicle 2 travels along the second rail R2, and a case where the traveling vehicle 2 travels from the first rail R1 to the second rail R2 or from the second rail R2 to the first rail R1.

Each rail unit 100 forms a square-shaped (or rectangular) track R that corresponds to a single square in the inside. A plurality of rail units 100 are aligned in the X and Y directions, so that a plurality of first rails R1 extend to be continuous in the X direction and a plurality of second rails R2 extend to be continuous in the Y direction. Two intersection rails R3 are arranged with a spacing between one first rail R1 and another first rail R1 on an X-direction line. Two intersection rails R3 are arranged with a spacing between one second rail R2 and another second rail R2 on a Y-direction line. The track R will be described in another perspective. When attention is paid to four squares including two squares aligned in the X direction and two squares aligned in the Y direction, four intersection rails R3 adjacent to each other in the X and Y directions are arranged with a spacing (relative to the first rail R1) between two first rails R1 adjacent to each other in the Y direction and other two first rails R1 adjacent to each other in the Y direction. The same four intersection rails R3 as described above are arranged with a spacing (relative to the second rail R2) between two second rails R2 adjacent to each other in the X direction and other two second rails R2 adjacent to each other in the X direction.

In the rail assembly 200, a plurality of first rails R1, a plurality of second rails R2, and a plurality of intersection rails R3 are arranged with a predetermined spacing from each other, thereby constructing the track R. A gap G corresponding to the spacing is formed between each first rail R1 and each intersection rail R3. A gap G corresponding to the spacing is formed between each second rail R2 and each intersection rail R3. The gaps G in the track R have a constant size. Each first rail R1 includes a flat and horizontal first travel surface R1a on its upper surface, and a traveling wheel 31 of the traveling vehicle 2 travels on the first travel surface R1a in the X direction (first traveling direction D1). Each second rail R2 includes a flat and horizontal second travel surface R2a on its upper surface, and the traveling wheel 31 of the traveling vehicle 2 travels on the second travel surface R2a in the Y direction (second traveling direction D2). The intersection rail R3 includes a flat and horizontal intersection travel surface R3a on its upper surface. The heights of the first travel surface R1a, the second travel surface R2a, and the intersection travel surface R3a are equal throughout the entire track R. The first travel surface R1a, the second travel surface R2a, and the intersection travel surface R3a are arranged on the same or almost the same horizontal plane.

For example, a gap having such a size as the gap G is not formed between the four intersection rails R3 described above. When the traveling vehicle 2 passes linearly through a plurality of rail units 100, the traveling wheel 31 of the traveling vehicle 2 travels on the intersection travel surface R3a. In doing so, the traveling wheel 31 passes on any two of the four intersection rails R3 described above. Alternatively, when the traveling vehicle 2 changes a traveling direction between the rail units 100 (when changing a traveling direction by 90 degrees, that is, when steering), the traveling wheel 31 of the traveling vehicle 2 passes on the intersection travel surface R3a (while changing direction).

As described above, in the rail assembly 200, the first rail members 110, the second rail members 120, and the intersection rail members 130 constitute the track R in a grid pattern. The layout of the track R formed in a grid pattern in the overhead traveling vehicle system 1 may be adjusted or modified as appropriate by arranging a plurality of rail units 100 into a desired matrix (including adding or removing the rail units 100).

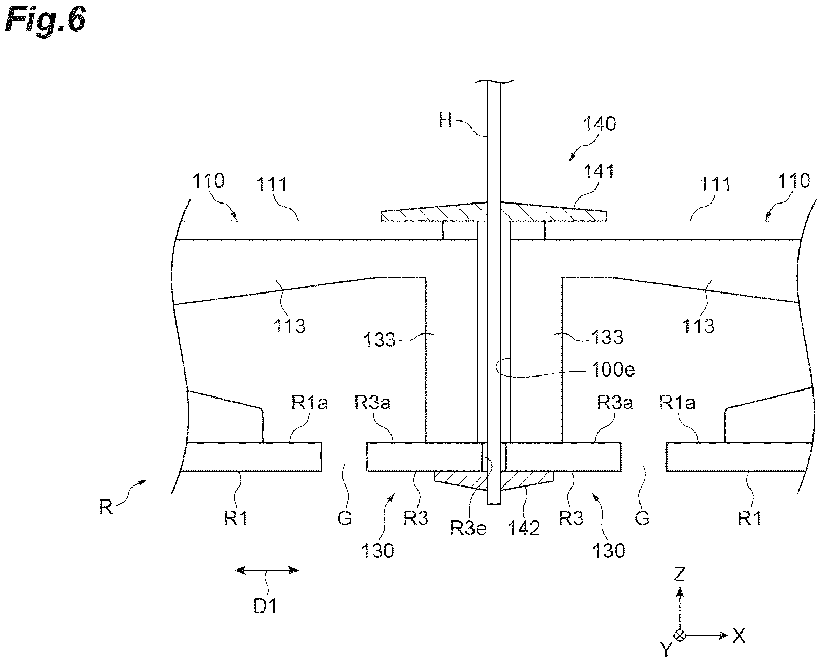

Referring to FIGS. 2 and 6, a coupling structure of the rail units 100 by the coupling members 140 will be described. As illustrated in FIGS. 2 and 6, each of the coupling members 140 includes an upper coupling member 141 and a lower coupling member 142. The upper coupling member 141 having a plate shape or a frame shape extending horizontally is attached to an upper surface of any one of four corners of a plurality of (typically four) rail units 100. The upper coupling member 141 abuts on the vicinity of an intersection of the first beam portion 111 and the second beam portion 121 in each rail unit 100. The lower coupling member 142 having a plate shape or a frame shape horizontally extending supports a lower surface of any one of four corners of a plurality of (typically four) rail units 100. The lower coupling member 142 abuts on the intersection rail R3 in each rail unit 100.

The suspension member H having a rod shape extending in the vertical direction passes through the upper coupling member 141 and the lower coupling member 142. The upper coupling member 141 and/or the lower coupling member 142 are fixed to the rail unit 100 by a not-illustrated fastening member or the like, whereby the rail units 100 are coupled to each other. A space 100e extending in the Z direction is formed between the rail units 100, and a space R3e extending in the Z direction is formed between four intersection rails R3 adjacent to each other in the X and Y directions (in a center portion in plan view). The suspension member H is inserted into the space 100e and the space R3e, and the upper coupling member 141 and/or the lower coupling member 142 are fixed to the suspension member H.

The overhead traveling vehicle system 1 includes a communication system (not illustrated). The communication system is used for communication between the traveling vehicle 2 and the system controller 5. The traveling vehicle 2 and the system controller 5 are communicatively connected via the communication system.

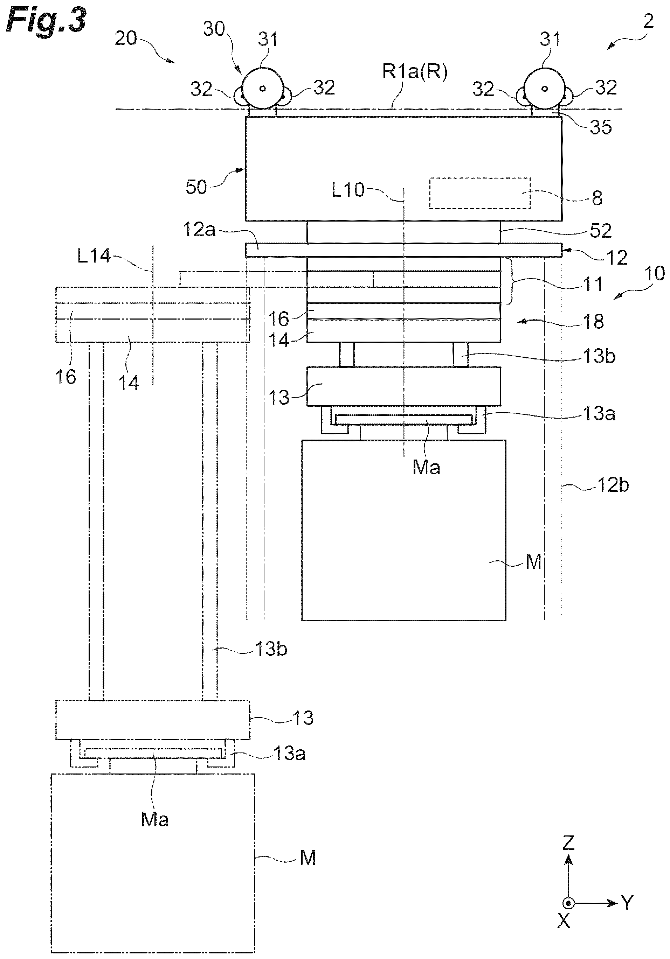

A configuration of the traveling vehicle 2 will now be described with reference to FIGS. 1, 3 and 4. As illustrated in FIGS. 1 and 3, the traveling vehicle 2 is provided so as to be able to travel along the track R. The traveling vehicle 2 has a traveling carriage 20 that travels on the track R, and a main body 10 that is attached to a lower portion of the traveling carriage 20 and can swivel relative to the traveling carriage 20. The traveling carriage 20 includes, for example, a rectangular carriage unit 50 arranged below the track R, a traveling section 30 provided at four corner positions of the carriage unit 50 in plan view and protruding upward from the carriage unit 50, and four wheel swiveling mechanisms 40 that swivel respective four traveling wheels 31 in the traveling section 30 relative to the carriage unit 50. The traveling section 30 and the wheel swiveling mechanisms 40 are integrated as one unit. A carriage controller (control unit) 8 is provided in the interior of the carriage unit 50.

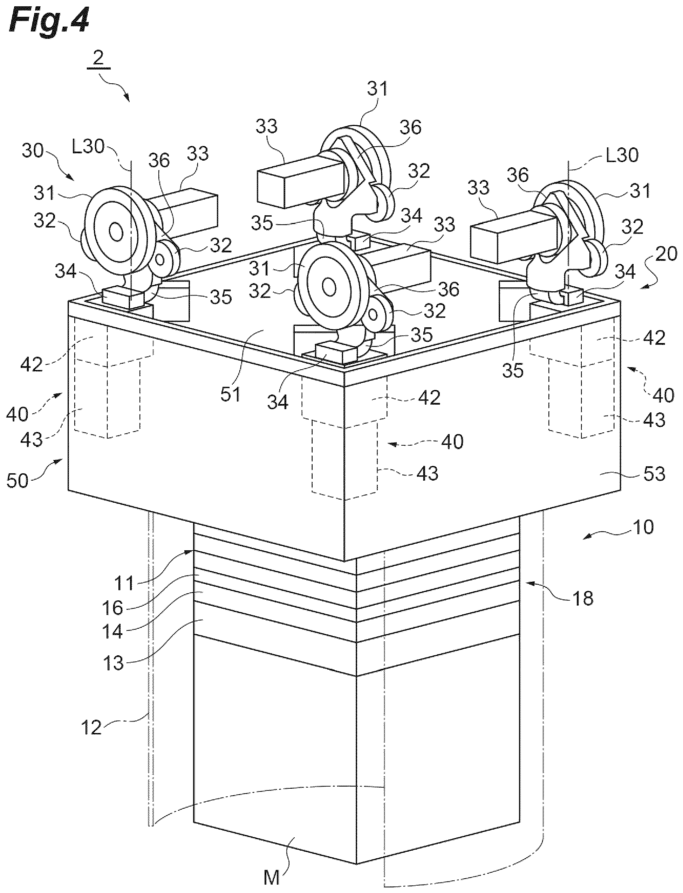

The main body 10 is arranged below the track R and is suspended from the traveling section 30. As illustrated in FIGS. 3 and 4, the main body 10 has a main body frame 12, for example, formed in a cylindrical shape. The main body frame 12 includes a disk-shaped top plate 12a and a cylindrical frame 12b hanging from a peripheral portion of the top plate 12a, and has a shape open at the bottom. The main body 10 is formed in dimensions that fit into one square in the track R in plan view (see FIG. 1). The traveling vehicle 2 can pass another traveling vehicle 2 traveling on the adjacent first rail R1 or second rail R2. The main body 10 includes a transfer device 18 arranged in the interior of the main body frame 12. The transfer device 18 is, for example, rectangular in plan view. The cylindrical frame 12b is open partially in the circumferential direction. An area having an opening (notch) is large enough to allow passage of the transfer device 18. When moving horizontally, the transfer device 18 passes through the opening of the cylindrical frame 12b.

The main body 10 is attached to a lower portion of the carriage unit 50 and can swivel relative to the carriage unit 50 around a rotation axis L10 in the Z direction. The traveling wheels 31 provided at four corner positions of the carriage unit 50 rest on the track R (on the first travel surface R1a, the second travel surface R2a, or the intersection travel surface R3a). The carriage unit 50 is suspended on the track R via four traveling wheels 31 and four wheel swiveling mechanisms 40. The four traveling wheels 31 allow the carriage unit 50 and the main body 10 to be stably suspended and allow the main body 10 to stably travel. In other words, the traveling vehicle 2 is suspended and supported by the traveling wheels 31 traveling along the track R, and moves below the track R.

The transfer device 18 moves in the horizontal direction relative to the main body 10 and transfers an article M to and from a load port (loading platform). The transfer device 18 is provided below the top plate 12a of the main body frame 12. The main body 10 including the transfer device 18 can rotate around the rotation axis L10 by a not-illustrated rotation driver such as an electric motor provided in the top plate 12a. The transfer device 18 has an article holder 13 that holds an article M beneath the track R, an elevation driver 14 that elevates and lowers the article holder 13 in the vertical direction, and a slide mechanism 11 that slides the elevation driver 14 in the horizontal direction. The slide mechanism 11 is held on a lower surface of the top plate 12a. A rotation driver 16 that drives to rotate the elevation driver 14 around a rotation axis L14 relative to the slide mechanism 11 is provided between the slide mechanism 11 and the elevation driver 14. The rotation driver 16 is provided below the slide mechanism 11, and the elevation driver 14 is provided below the rotation driver 16. The article holder 13 is provided below the elevation driver 14 via a plurality of suspension members 13b. The load port is a point to or from which the traveling vehicle 2 is transferred and where an article M is received from and delivered to the traveling vehicle 2.

The article holder 13 grips a flange portion Ma of the article M and thereby holds the article M in a suspended manner. The article holder 13 is, for example, a chuck having a hook 13a movable in the horizontal direction. The article holder 13 holds the article M by advancing the hook 13a below the flange portion Ma of the article M and elevating the article holder 13. The article holder 13 is connected to the suspension member 13b such as a wire or a belt.

The elevation driver 14, which is, for example, a hoist, lowers the article holder 13 by unreeling the suspension member 13b and elevates the article holder 13 by reeling the suspension member 13b. The elevation driver 14 is controlled by the carriage controller 8 to lower or elevate the article holder 13 at a predetermined speed. The elevation driver 14 is controlled by the carriage controller 8 to hold the article holder 13 at a target height.

The slide mechanism 11 has, for example, a plurality of movable plates arranged on top of each other in the Z direction. By swiveling the main body 10, the slide mechanism 11 moves the rotation driver 16, the elevation driver 14, and the article holder 13 attached to the lowest movable plate in any direction in a horizontal plane. The swivel angle of the main body 10 relative to the carriage unit 50 determines the direction of movement of the movable plates in the slide mechanism 11. In the main body 10, the orientation of the transfer device 18 and the main body frame 12 is set such that the direction of movement of the movable plates match the position of the opening of the cylindrical frame 12b.

The rotation driver 16 includes, for example, an electric motor and rotates the elevation driver 14 (and the article holder 13) within a predetermined angular range around the rotation axis L14 extending in the vertical direction. The angle of rotation allowed by the rotation driver 16 is any angle, for example, equal to or less than 180 degrees, but the upper limit is not limited to 180 degrees. The article holder 13 (or the article M held by the article holder 13) moved laterally can be directed in a desired orientation by the rotation driver 16. The slide mechanism 11 and the rotation driver 16 are controlled by the carriage controller 8. Even in a state in which the movable plates of the slide mechanism 11 are stored without being moved (a state indicated by the solid line in FIG. 3), the rotation of the elevation driver 14 by the rotation driver 16 is possible. In this case, for example, the rotation axis L14 of the elevation driver 14 coincides with the rotation axis L10 of the main body 10.

The carriage unit 50 has a cylindrical support member (cylindrical member) 52 at its lower end. The top plate 12a of the main body frame 12 is rotatably attached to the underside of the support member 52. For example, a not-illustrated rotation driver, such as an electric motor, is provided in the top plate 12a. A driving force of the rotation driver is transmitted to the support member 52, causing the main body frame 12 to rotate relative to the carriage unit 50 around the rotation axis L10 extending in the vertical direction. The angle at which the main body frame 12 can rotate is any angle, for example, 360 to 540 degrees, but the upper limit is not limited to 540 degrees and the lower limit is not limited to 360 degrees. The slide mechanism 11 is attached to the underside of the top plate 12a, and the top plate 12a supports the slide mechanism 11. The main body frame 12 and the transfer device 18 are integrated, and the main body frame 12 and the transfer device 18 rotate together. The traveling vehicle 2 can receive and deliver an article M to the load port by using the transfer device 18.

A not-illustrated cover may be attached to the outer side of the cylindrical frame 12b. In this case, the cover encloses the transfer device 18 and the article M held by the transfer device 18. The cover has a cylindrical shape with an open lower end and has a notch (the opening described above) where the movable plates of the slide mechanism 11 protrude.

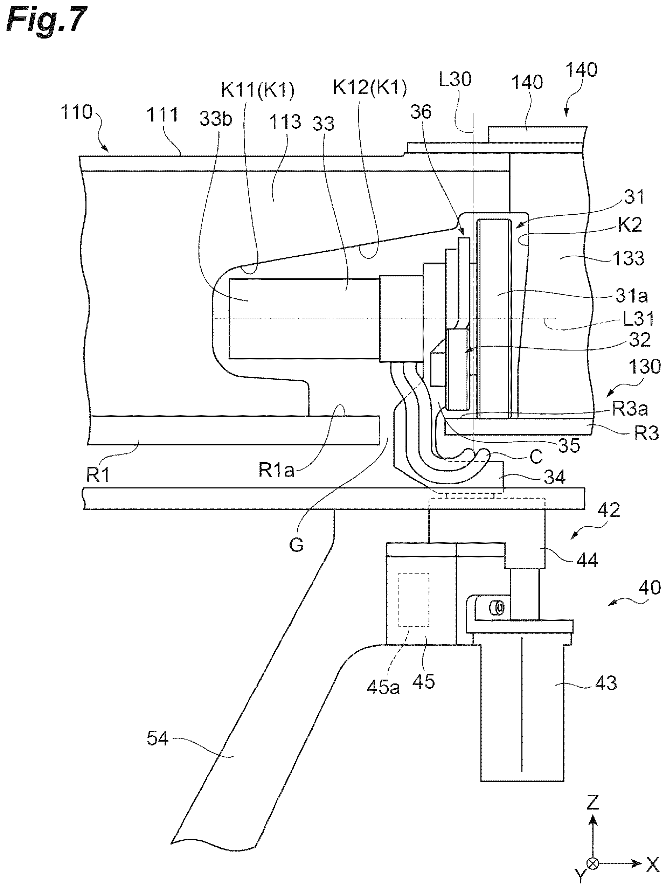

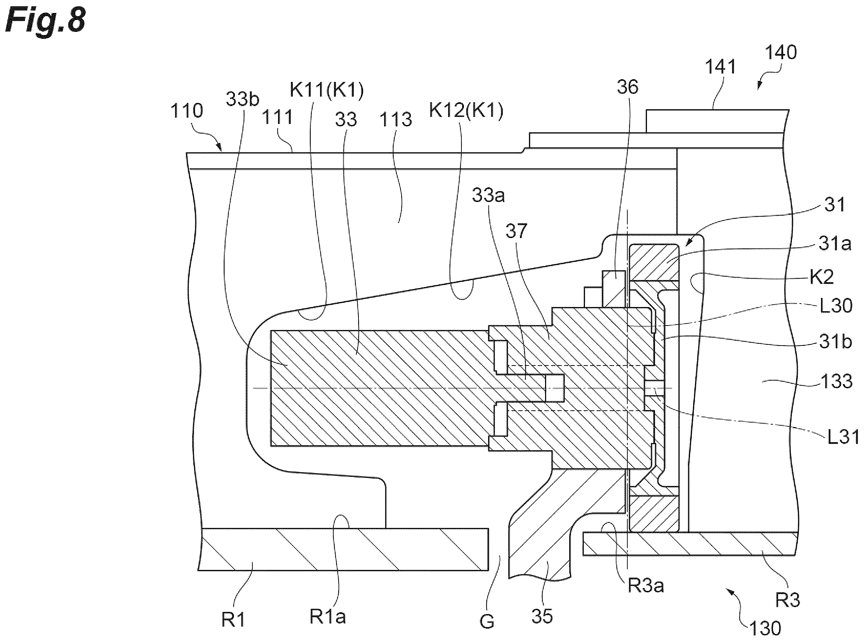

The traveling section 30 has four traveling wheels 31. Each of the traveling wheels 31 has two auxiliary wheels 32. As illustrated in FIG. 4, the traveling wheels 31 are provided at four corner positions of the carriage unit 50 so as to protrude upward from a top cover 51. Each traveling wheel 31 can rotate around the axis of a horizontal or approximately horizontal axle along the XY plane. A traveling drive motor 33 is provided on a rotation axis L31 of each traveling wheel 31. Each traveling wheel 31 is driven to rotate by a driving force of the traveling drive motor 33. The traveling drive motor 33 is configured to, for example, switch between forward rotation and reverse rotation. Each of the traveling wheels 31 rolls on the track R about the rotation axis L31 as a principal axis (see FIGS. 7 and 8). Each of the traveling wheels 31 rolls on the travel surfaces R1a, R2a, and R3a of the first rail R1, the second rail R2, and the intersection rail R3 to allow the traveling vehicle 2 to travel. In other words, the traveling section 30 travels along the track R. Not all of the four traveling wheels 31 are driven to rotate by the driving force of the traveling drive motor 33, and one or some of the four traveling wheels 31 may be driven to rotate.

Four wheel swiveling mechanisms 40 (steering drivers) are fixed to a not-illustrated frame in the carriage unit 50, and a base 34 is coupled to each of the wheel swiveling mechanisms 40 via a swivel axis of the wheel swiveling mechanism 40. The traveling wheel 31, two auxiliary wheels 32, and one traveling drive motor 33 are mounted on the base 34 via a coupling section 35 and a support section 36 (support member). For example, the top cover 51 having a square shape is provided on the top of an enclosure 53, and the base 34 is arranged in a notch formed at each of four corners of the top cover 51. The coupling section 35, the traveling wheel 31, the auxiliary wheels 32, and the traveling drive motor 33 are arranged above the top cover 51.

As illustrated in FIGS. 3 and 4, the coupling section 35 couples the carriage unit 50 (more specifically, the wheel swiveling mechanism 40 fixed in the carriage unit 50) to the traveling wheel 31. With this coupling structure, the carriage unit 50 and the main body 10 are arranged below the track R and suspended from the traveling section 30. The coupling section 35 is formed with a thickness that can pass through the gap G between the first rail R1 and the intersection rail R3, and between the second rail R2 and the intersection rail R3. The support section 36 is provided at an upper portion of the coupling section 35 to support the rotation axis of the traveling wheel 31 and the rotation axis of the auxiliary wheel 32 in a rotatable manner. The support section 36 holds a relative position between the traveling wheel 31 and the auxiliary wheels 32.

As illustrated in FIG. 4, the traveling wheel 31 is provided so as to able to swivel about a swivel axis L30 as a principal axis extending in the vertical direction. Four swivel axes L30 are arranged at the apexes of a square in plan view, and the rotation axis L10 is arranged at the center of the swivel axes L30. In other words, four swivel axes L30 are arranged at four-fold symmetry positions with respect to the rotation axis L10 of the main body 10. In plan view, the position of the traveling wheel 31 is different (displaced) from the position of the swivel axis L30. The traveling wheel 31 can be swiveled by the wheel swiveling mechanism 40 and consequently change the traveling direction of the traveling vehicle 2.

The auxiliary wheels 32 are arranged one in each of the front and the back of the traveling wheel 31 in the traveling direction. Each of the auxiliary wheels 32 can rotate around the axis of a horizontal or approximately horizontal axle along the XY plane. The lower end of the auxiliary wheel 32 is set, for example, higher than the lower end of the traveling wheel 31. Thus, when the traveling wheel 31 is traveling on the travel surfaces R1a, R2a, and R3a, the auxiliary wheels 32 do not contact the travel surfaces R1a, R2a, and R3a. When the traveling wheel 31 passes through the gap G between the first rail R1 and the intersection rail R3 and between the second rail R2 and the intersection rail R3, the auxiliary wheels 32 contact a not-illustrated auxiliary member provided on the first rail R1 and the second rail R2 to prevent the traveling wheel 31 from dropping. The configuration is not limited to two auxiliary wheels 32 for one traveling wheel 31. For example, one auxiliary wheel 32 may be provided for one traveling wheel 31, or no auxiliary wheel 32 may be provided.

The wheel swiveling mechanism 40 is a mechanism that swivels the traveling wheel 31. Four wheel swiveling mechanisms 40 are arranged, for example, one at each of four corner positions in the enclosure 53 of the carriage unit 50. Each of the wheel swiveling mechanisms 40 has a steering motor 43 and a driving force transmission 42 provided between the steering motor 43 and the traveling wheel 31. The driving force transmission 42 is fixed to a not-illustrated frame in the carriage unit 50. The driving force transmission 42 is coupled to the base 34 via the swivel axis. Each wheel swiveling mechanism 40 swivels the base 34, the coupling section 35, the support section 36, the traveling wheel 31, the auxiliary wheels 32, and the traveling drive motor 33 integrally around the swivel axis L30. In a state in which the traveling vehicle 2 is located at the center of each rail unit 100, each of the traveling wheels 31 is swiveled 90 degrees about the corresponding swivel axis L30 as a principal axis. Thus, the traveling wheel 31 swivels on the intersection rail R3. As a result, the traveling vehicle 2 can turn. As used herein, "turn" is to switch from a first state in which the traveling vehicle 2 travels in a first traveling direction D1 to a second state in which the traveling vehicle 2 travels in a second traveling direction D2, or from the second state in which the traveling vehicle 2 travels in the second traveling direction D2 to the first state in which the traveling vehicle 2 travels in the first traveling direction D1. The turn of the traveling vehicle 2 is performed, for example, in a stop state of the traveling vehicle 2. The turn of the traveling vehicle 2 may be performed in a state in which the traveling vehicle 2 stops, but the article M is moving (for example, swiveling). The driving of the wheel swiveling mechanisms 40 is controlled by the carriage controller 8.

The carriage controller 8 centrally controls the traveling vehicle 2. The carriage controller 8 is a computer including a central processing unit (CPU), a read only memory (ROM), and a random access memory (RAM). The carriage controller 8 can be configured as software, for example, as a program stored in the ROM, loaded onto the RAM, and executed by the CPU. The carriage controller 8 may be configured as hardware using an electronic circuit or the like. The carriage controller 8 may be configured with a single device or a plurality of devices. When the carriage controller 8 is configured with a plurality of devices, they are connected via a communication network, such as the Internet or an intranet, to logically construct a single carriage controller 8. The carriage controller 8 is provided, for example, in the carriage unit 50.

The carriage controller 8 controls the traveling of the traveling vehicle 2 based on a transport command. The carriage controller 8 controls the traveling of the traveling vehicle 2 by controlling the traveling drive motor 33, the steering motor 43, and the like. The carriage controller 8 controls, for example, a travel speed, an operation related to stopping, and an operation related to changing direction. The carriage controller 8 controls a transfer operation of the traveling vehicle 2 based on a transport command. The carriage controller 8 controls a transfer direction of the transfer device 18 by controlling the swiveling (rotation) of the main body 10 (the main body frame 12 and the transfer device 18). The carriage controller 8 controls a transfer operation of the traveling vehicle 2 by controlling the transfer device 18 and the like. The carriage controller 8 controls a holding operation of gripping the article M arranged at a predetermined load port, and an unloading operation of putting the held article M down to a predetermined load port.

The system controller 5 is a computer including a CPU, a ROM, and a RAM. The system controller 5 can be configured as software, for example, as a program stored in the ROM, loaded onto the RAM, and executed by the CPU. The system controller 5 may be configured as hardware using an electronic circuit or the like. The system controller 5 may be configured with a single device or a plurality of devices. When the system controller 5 is configured with a plurality of devices, they are connected via a communication network, such as the Internet or an intranet, to logically construct a single system controller 5. At least part of various controls of the system controller 5 may be performed by the carriage controller 8.

The system controller 5 selects any of a plurality of traveling vehicles 2 that can transport an article M, and gives a transport command to the selected traveling vehicle 2. The transport command includes a travel command to execute traveling of the traveling vehicle 2 to a load port, and a command for holding the article M arranged at the load port or a command for unloading the held article M to the load port.

Referring now to FIGS. 7 and 8, the traveling section 30 will be described in detail. FIGS. 7 and 8 illustrate an example in which the traveling wheel 31 travels on the intersection travel surface R3a in the Y direction. FIG. 8 illustrates a cross-section along the XZ plane of the traveling section 30. The traveling section 30 has the traveling wheel 31, the traveling drive motor 33, the support section 36, and the coupling section 35, as described above. The traveling wheel 31 rolls on the track R about the rotation axis L31 as a principal axis. The traveling wheel 31 swivels about the swivel axis L30 as a principal axis. In this case, since the swivel axis L30 is located on the intersection rail R3, the traveling wheel 31 can swivel on the intersection rail R3. The traveling wheel 31 includes an outer ring portion 31a and a wheel portion 31b.

The traveling drive motor 33 is a drive source that generates a driving force for rotating the traveling wheel 31. The traveling drive motor 33 drives the traveling wheel 31. The traveling drive motor 33 is arranged such that an output shaft 33a of the traveling drive motor 33 is coaxial to the rotation axis L31 of the traveling wheel 31. The traveling drive motor 33 is provided on the rotation axis L31 of the traveling wheel 31. Specifically, the traveling drive motor 33 is arranged so as to overlap the rotation axis L31 when viewed from a direction along the rotation axis L31. The output shaft 33a of the traveling drive motor 33 is connected to the wheel portion 31b of the traveling wheel 31 with a connection section 37 interposed therebetween. The connection section 37 includes, for example, a speed reducer that reduces the rotational speed of the traveling drive motor 33, and an axle that transmits the driving force of the traveling drive motor 33 to the traveling wheel 31.

The traveling drive motor 33 has an outer diameter smaller than the outer diameter of the traveling wheel 31. When viewed from the axial direction of the rotation axis L31, the traveling drive motor 33 has an outer shape included in the outer shape of the traveling wheel 31. A cable Ca is electrically connected to the traveling drive motor 33. The traveling drive motor 33 is electrically connected to the carriage controller 8 described below via the cable Ca. The traveling drive motor 33 is driven based on a command input from the carriage controller 8, whereby the traveling wheel 31 is driven to rotate.

The support section 36 supports the traveling wheel 31 and the auxiliary wheels 32 such that the traveling wheel 31 and the auxiliary wheels 32 can rotate. In other words, the support section 36 supports the axle of the traveling wheel 31 such that the traveling wheel 31 can rotate in a rotation direction around the rotation axis L31. The support section 36 supports the axle of each of the auxiliary wheels 32 such that the auxiliary wheel 32 can rotate in a rotation direction around the rotation axis of the auxiliary wheel 32. In the example illustrated in the drawings, the support section 36 extends vertically, supports the traveling wheel 31 via the connection section 37 such that the traveling wheel 31 can rotate, and supports the auxiliary wheels 32 such that the auxiliary wheels 32 can rotate.

The coupling section 35 is coupled to a lower portion of the support section 36. In the example illustrated in the drawings, the coupling section 35 extends downward from the lower portion of the support section 36 while bending inward (toward the traveling drive motor 33), extends linearly downward, and then extends so as to bend outward (toward the traveling wheel 31). The cable Ca is arranged along the coupling section 35. The coupling section 35 and the cable Ca extend from above to below the track R through the gap G, for example, when the traveling vehicle 2 travels on the first rail R1 and crosses the second rail R2, or when the traveling vehicle 2 travels on the second rail R2 and crosses the first rail R1 (see FIG. 7). The base 34 is an approximately rectangular parallelepiped-shaped section continuous with the lower portion of the coupling section 35 (see FIG. 4). For example, the base 34 is fixed at an upper end portion of a swivel cylinder 48.

As illustrated in FIGS. 2 and 8, the first support walls (support walls) 113 are connected to the upper surfaces of a plurality of first rails R1, and the second support walls (support walls) 123 are connected to the upper surfaces of a plurality of second rails R2. The first support walls 113 and the second support walls 123 each have a first notch K1. The first notch K1 allows passage of the traveling section 30 during traveling of the traveling vehicle 2. For example, the first notch K1 and a second notch K2 allow passage of the traveling wheel 31 and the traveling drive motor 33.

When viewed from the Y direction, the first notch K1 of the first support wall 113 has such a shape that an end portion in the X direction of the first support wall 113 is notched to open outward in the X direction. When viewed from the X direction, the first notch K1 of the second support wall 123 has such a shape that an end portion in the Y direction of the second support wall 123 is notched to open outward in the Y direction. The first notch K1 includes a first portion K11 and a second portion K12. The first portion K11 and the second portion K12 are continuous with each other. The first portion K11 allows passage of a portion of the traveling drive motor 33 on the opposite side of the traveling wheel 31. The second portion K12 allows passage of the other portion of the traveling drive motor 33, the connection section 37, the support section 36, the traveling wheel 31, and the auxiliary wheels 32.

The second notch K2 is formed in a side portion of the intersection support column 133. The second notch K2 allows passage of the traveling wheel 31 and the auxiliary wheels 32. The second notch K2 has such a shape that is notched to open to the first support wall 113 or the second support wall 123. The second notch K2 is formed so as to be continuous with the first notch K1. The second notch K2 may be omitted.

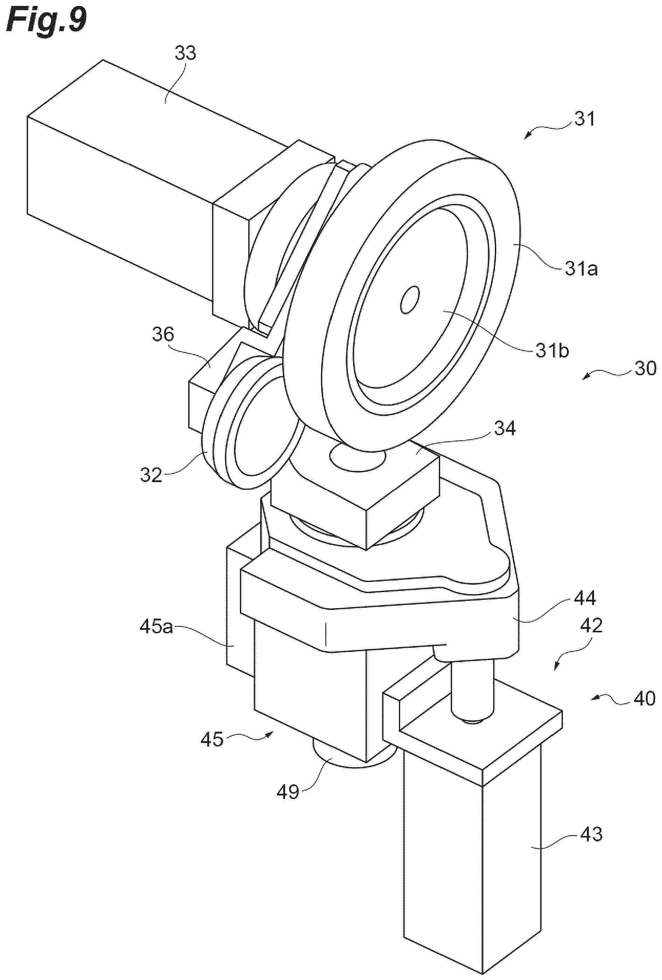

Referring now to FIGS. 7 and 9 to 11, the wheel swiveling mechanism (steering driver) 40 will be described in detail. As illustrated in FIG. 7, the wheel swiveling mechanism 40 is provided below the track R and below the traveling wheel 31. As illustrated in FIGS. 9 to 11, the driving force transmission 42 of the wheel swiveling mechanism 40 is a mechanism that transmits a driving force generated in the steering motor 43 to the traveling section 30. The driving force transmission 42 has a gearbox 44, an enclosure 45, and the swivel cylinder 48. The gearbox 44 is provided below the base 34. The enclosure 45 is arranged below the gearbox 44. A fixing member 45a is provided on a side surface of the enclosure 45. The enclosure 45 is fixed to a frame 54 in the carriage unit 50 via the fixing member 45a (see FIG. 7).

The swivel cylinder 48 has, for example, a cylindrical shape. The swivel cylinder 48 has the swivel axis L30 as its axial direction and passes through the gearbox 44 and the enclosure 45. The swivel cylinder 48 is provided to be rotatable about the swivel axis L30 as a principal axis relative to the gearbox 44 and the enclosure 45. The base 34 is connected to an upper end portion of the swivel cylinder 48. The swivel cylinder 48 has a lower end portion protruding downward from the enclosure 45. The lower end portion of the swivel cylinder 48 has a slipping-off preventing member 49. The slipping-off preventing member 49 has an outer diameter larger than the outer diameter of a through hole through which the swivel cylinder 48 passes in the enclosure 45. This prevents the swivel cylinder 48 from slipping off upward.

The steering motor 43 of the wheel swiveling mechanism 40 is a drive source that generates a driving force for swiveling. The steering motor 43 is arranged below the gearbox 44. The steering motor 43 is fixed to the enclosure 45. The steering motor 43 has an output shaft 43b provided parallel to the swivel axis L30. The output shaft 43b is connected to the driving force transmission 42.

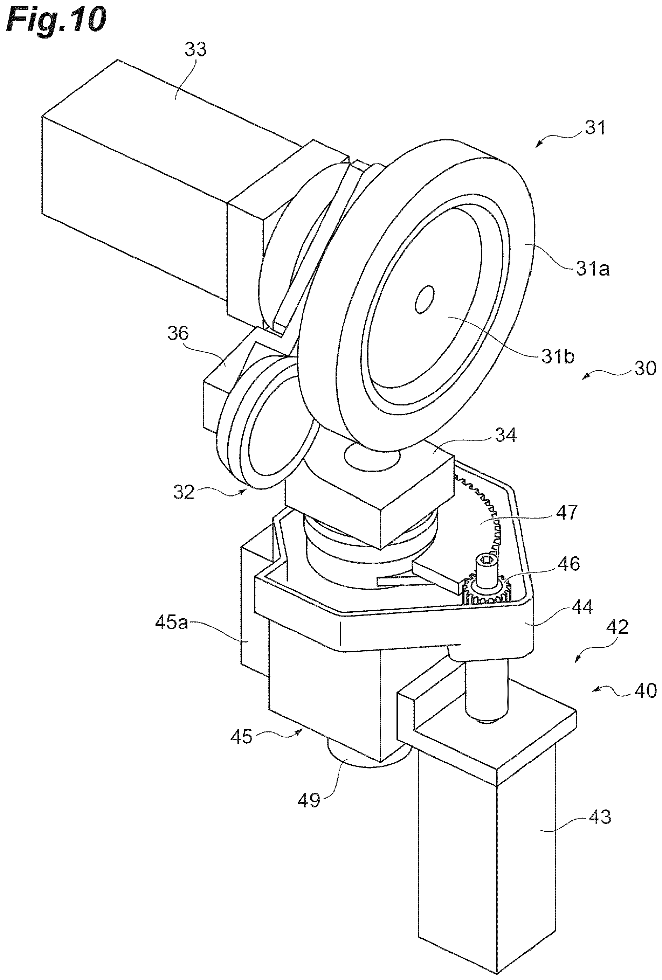

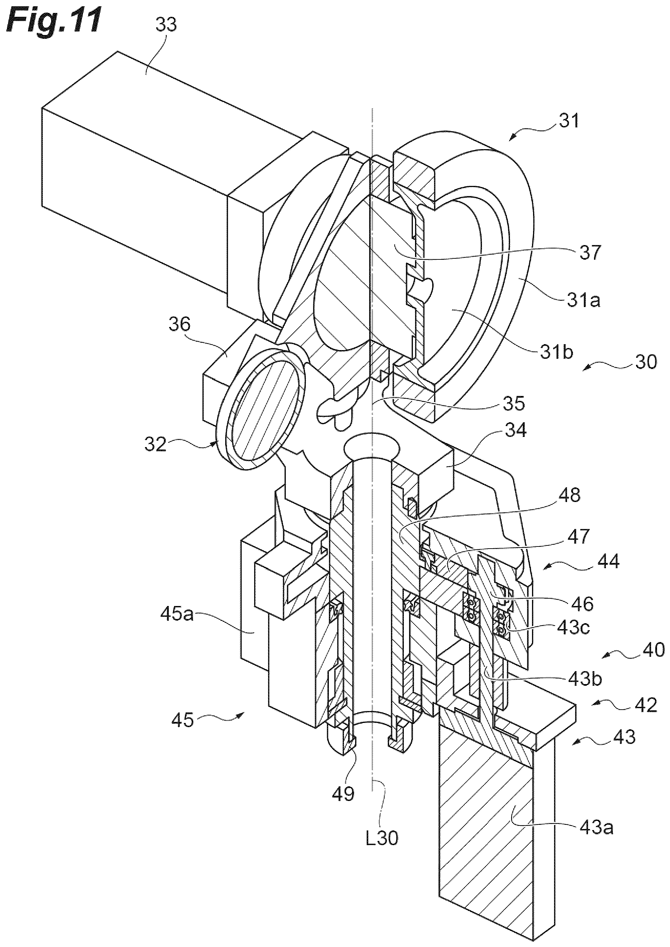

As illustrated in FIGS. 10 and 11, the gearbox 44 has a first gear 46, a second gear 47, and a bearing 43c inside. The first gear 46 is, for example, a spur gear. The first gear 46 is arranged with the vertical direction as its axial direction. The first gear 46 is coaxially connected to the output shaft 43b of the steering motor 43. The second gear 47 is, for example, a sector gear. The second gear 47 is arranged with the swivel axis L30 as its axial direction. The second gear 47 meshes with the first gear 46. The second gear 47 is engaged with an outer peripheral surface of the swivel cylinder 48 in the rotation direction around the swivel axis L30. For example, a cylindrical body to which an inner peripheral surface of the second gear 47 is fixed can rotate in the rotation direction around the swivel axis L30, and an inner peripheral surface of the cylindrical body and the outer peripheral surface of the swivel cylinder 48 can rotate synchronously so as to be integrated in the rotation direction via a key seat. The second gear 47 is thus connected to the support section 36 via the swivel cylinder 48, the base 34, and the coupling section 35. The bearing 43c supports the output shaft 43b of the steering motor 43 such that the output shaft 43b can rotate. The bearing 43c is arranged below the first gear 46.

In the wheel swiveling mechanism 40 configured as described above, when the traveling wheel 31 is to be swiveled, a driving force is first generated by the steering motor 43, and the driving force is transmitted to the first gear 46 via the output shaft 43b. As a result, the first gear 46 rotates, and the second gear 47 meshed with the first gear 46 rotates about the swivel axis L30 as a principal axis. In synchronization with the rotation of the second gear 47, the swivel cylinder 48 rotates, for example, 90 degrees about the swivel axis L30 as a principal axis. As a result, the base 34, the coupling section 35, and the support section 36 rotate 90 degrees about the swivel axis L30 as a principal axis, and the traveling wheel 31 swivels 90 degrees about the swivel axis L30 as a principal axis.

A guide roller in abutment with a side surface of the intersection rail R3 may be provided between the traveling wheel 31 and the wheel swiveling mechanism 40 (for example, in the vicinity of the coupling section 35). The guide roller prevents displacement of the traveling carriage 20 (traveling vehicle 2) relative to the track R.

In the overhead traveling vehicle system 1 described above, the traveling drive motor 33 that drives the traveling wheel 31 is provided on the rotation axis L31 of the traveling wheel 31 that rolls on the track R. In the overhead traveling vehicle system 1, therefore, a space above the track R can be effectively utilized to arrange the traveling drive motor 33. As a result, for example, the height dimension from the traveling drive motor 33 to the traveling wheel 31 is reduced, so that the traveling section 30 can be downsized. A compact system can be achieved.

In the overhead traveling vehicle system 1, the first support wall 113 and the second support wall 123 are respectively connected to the upper surfaces of each of a plurality of first rails R1 and each of a plurality of second rails R2, and the first support wall 113 and the second support wall 123 each have the first notch K1 that allows passage of the traveling drive motor 33 during traveling of the traveling vehicle 2. In this case, the first support wall 113 and the second support wall 123 increase the strength of the track R, and the first notch K1 avoids interference of the traveling drive motor 33 with the first support wall 113 and the second support wall 123.

In the overhead traveling vehicle system 1, the wheel swiveling mechanism 40 is provided below the track R and below the traveling wheel 31. In this case, the wheel swiveling mechanism 40 can be arranged in a dead space below the track R and below the traveling wheel 31. This eliminates the need for arranging the wheel swiveling mechanism 40 between the top cover 51 of the carriage unit 50 and the track R, thereby reducing the height dimension of the traveling vehicle 2. As a result, the traveling vehicle 2 can be downsized.

In the overhead traveling vehicle system 1, the outer shape of the traveling drive motor 33 is included in the outer shape of the traveling wheel 31, when viewed from the axial direction of the rotation axis L31. In this case, the diameter of the traveling wheel 31 can be increased to achieve a well-balanced structure of the traveling section 30 in the traveling vehicle 2. With the larger traveling wheel 31, the traveling of the traveling vehicle 2 becomes more stable and the overhead traveling vehicle 2 can carry a heavier load (the load capacity of the traveling vehicle 2 is increased). Further, the traveling wheel 31 can move across the gap G more reliably. In addition, size increase of the traveling section 30 due to the traveling drive motor 33 can be suppressed.

In the overhead traveling vehicle system 1, the coupling section 35 and the cable C pass through the gap G, for example, when the traveling vehicle 2 travels on the first rail R1 and crosses the second rail R2, or when the traveling vehicle 2 travels on the second rail R2 and crosses the first rail R1. Since it is unnecessary to provide the coupling section 35 with a transmission mechanism such as a belt that transmits a driving force to the traveling wheel 31, the strength of the coupling section 35 and the like can be increased.

The overhead traveling vehicle system 1 does not require a transmission mechanism such as a belt between the traveling drive motor 33 and the traveling wheel 31 and consequently has the following effects. Backlash can be reduced and rigidity can be increased. Stop position accuracy can be increased. The size of the guide roller can be increased. The structure can be simplified and the productivity can be improved.

In the overhead traveling vehicle system 1 according to the present embodiment, the wheel swiveling mechanism 40 can be formed as a unit. As a result, the productivity of the wheel swiveling mechanism 40 is improved, and in addition, the ease of replacement and inspection of the wheel swiveling mechanism 40 is improved.

In the overhead traveling vehicle system 1 according to the present embodiment, the first gear 46 and the second gear 47 are provided not on the top cover 51 of the carriage unit 50, but in the interior of the gearbox 44. Thus, compared with a structure in which gears such as rack gear are directly provided on the main body 10, friction between gears, for example, caused by vibration in traveling can be suppressed.

Although embodiments have been described above, an aspect of the present invention is not limited to the above embodiments, and various changes can be made without departing from the spirit of the invention.

In the above embodiment, the traveling drive motor 33 is arranged such that the output shaft 33a of the traveling drive motor 33 is coaxial to the rotation axis L31, but the embodiments are not limited thereto. As long as the traveling drive motor 33 is arranged on the rotation axis L31, the output shaft 33a may be shifted from the rotation axis L31.

In the above embodiment, a case where the traveling vehicle is an overhead traveling vehicle has been described, but the traveling vehicle may be a rail-guided carriage that travels on a track provided on the ground. In the above embodiment, a grid system is employed as the overhead traveling vehicle system 1, but the overhead traveling vehicle system 1 is not limited to a grid system. For example, an automated guided vehicle (AGV) may be employed as the overhead traveling vehicle system, or various known systems that travel on a grid-like travel path may be employed.

Various materials and shapes can be applied to each configuration in the above embodiment and modifications, not limited to the materials and shapes described above. Each configuration in the above embodiment or modifications can be applied as desired to each configuration in other embodiments or modifications. Each configuration in the above embodiment or modifications can be partially omitted as appropriate without departing from the spirit of one aspect of the present invention.

### Reference Signs List

1 overhead traveling vehicle system
2 overhead traveling vehicle
10 main body
30 traveling section
31 traveling wheel
33 traveling drive motor
35 coupling section
36 support section
40 wheel swiveling mechanism (steering driver)
113 first support wall (support wall)
123 second support wall (support wall)
C cable
G gap
K1 first notch (notch)
R track
R1 first rail
R2 second rail
R3 intersection rail
L30 swivel axis
L31 rotation axis

## Claims

1. An overhead traveling vehicle system comprising:
a track at least partially disposed in a grid pattern; and
an overhead traveling vehicle including a traveling section configured to travel along the track, and a main body disposed below the track and suspended from the traveling section,
the traveling section including
a traveling wheel configured to roll on the track about a rotation axis as a principal axis, and
a traveling drive motor configured to drive the traveling wheel, wherein
the traveling drive motor is disposed on the rotation axis of the traveling wheel.

2. The overhead traveling vehicle system according to claim 1, wherein
the track has a plurality of first rails extending along a first direction and a plurality of second rails extending along a second direction intersecting the first direction,
a support wall is connected to an upper surface of each of the first rails and the second rails, and
the support wall has a notch that allows passage of the traveling drive motor during traveling of the overhead traveling vehicle.

3. The overhead traveling vehicle system according to claim 1 or 2, wherein
the traveling wheel is capable of swiveling,
the overhead traveling vehicle system further comprises a steering driver configured to swivel the traveling wheel, and
the steering driver is disposed below the track and below the traveling wheel.

4. The overhead traveling vehicle system according to claim 1 or 2, wherein the traveling drive motor has an outer shape included in an outer shape of the traveling wheel, as viewed from an axial direction of the rotation axis.

5. The overhead traveling vehicle system according to claim 2, further comprising:
a support section configured to support the traveling wheel such that the traveling wheel is rotatable;
a coupling section coupled to a lower portion of the support section; and
a cable electrically connected to the traveling drive motor, wherein
the rails include a plurality of intersection rails disposed with a gap from each of end portions of the first rails and end portions of the second rails,
the coupling section and the cable extend from above to below the track through the gap.
